# EUROPEAN PATENT APPLICATION

(11) **EP 4 819 813 A1**
(43) Date of publication of application: **07.10.2026**
(21) Application number: 23960885.4
(22) Date of filing: 04.12.2023
(51) Int. Cl.: H10K 59/80, G09F 9/30, G06F 1/16, H04N 5/65, H05K 5/03, F16H 7/02, H10K 102/00

(54) **DISPLAY DEVICE**

(71) Applicant: LG Electronics Inc., Yeongdeungpo-gu Seoul 07336 (KR)
(72) Inventor: LEE, Myungho, Seoul 06772 (KR); HWANG, Sungho, Seoul 06772 (KR); HWANG, Hodong, Seoul 06772 (KR)
(74) Representative: Schornack, Oliver
(86) International application number: PCT/KR2023/019825
(87) International publication number: WO 2025/121455

(57) **Abstract**

A display device is disclosed. The display device comprises: a display panel, which displays an image and has a light-transmissive property; a transparent panel facing the display panel; a side frame elongated along the lateral side of the display panel and coupled to the transparent panel; a belt, which is provided in the side frame and moves in the longitudinal direction of the side frame; a bar, which is elongated in the direction intersecting the side frame and has one end fixed to the belt; a roller, which is adjacent to the lower side connected to the lateral side of the display panel, is elongated along the lower side of the display panel, and can rotate; a light-shielding film, which has one end fixed to the bar and the other end coupled to the roller such that the light-shielding film is wound around or unwound from the roller when the bar moves; an upper pulley which is disposed above the side frame, and around which the belt is wound; and a driving pulley, which is adjacent to the bottom of the side frame, faces the light-shielding film, and rotates around the thickness direction, as an axis, of the light-shielding film, and has the belt wound therearound, wherein the bar can include: a piece body around which the light-shielding film is wound; and a moving block, which moves relative to the piece body in the longitudinal direction of the side frame, is coupled to the piece body, and has the belt fixed thereto.

## Description

### [Technical Field]

The present disclosure relates to a display device. More specifically, the present disclosure relates to a display device including a transparent display panel.

### [Background Art]

As the information society develops, the demand for display devices is increasing in various manners. In response to this, various display devices such as a liquid crystal display (LCD), a plasma display panel (PDP), an electroluminescent display (ELD), a vacuum fluorescent display (VFD), and an organic light emitting diode (OLED) display have recently been researched and are being used.

Thereamong, an LCD panel is equipped with a TFT substrate and a color substrate facing each other with a liquid crystal layer interposed therebetween, and can display images using light provided by a backlight unit. Additionally, an OLED panel can display images using a self-emissive organic layer formed on a substrate on which a transparent electrode is formed.

Recently, much research has been conducted on transparent display panels that not only display images to users but also allow users to view behind the display panels.

### [Disclosure]

### [Technical Problem]

An object of the present disclosure is to solve the aforementioned problems and other problems.

Another object may be to provide a display device having a transparent display panel.

Another object may be to provide a structure and a driving mechanism for opening and closing the rear surface of the transparent display panel.

Another object may be to provide a frame structure in which the transparent display panel and a light-shielding film are combined.

Another object may be to provide a driving mechanism for a film for shielding the transparent display panel.

Another object may be to provide a structure capable of controlling the left-right balance of the light-shielding film.

Another object may be to provide a structure capable of fine-tuning the initial position of the light-shielding film.

Another object may be to provide a structure capable of providing uniform tension to the light-shielding film.

### [Technical Solution]

According to one aspect of the present disclosure to accomplish the aforementioned or other objects, a display device includes a display panel which displays an image and is transparent, a transparent panel facing the display panel, a side frame extending along a side edge of the display panel and coupled to the transparent panel, a belt provided in the side frame and moving in a longitudinal direction of the side frame, a bar extending in a direction intersecting the side frame and having one end fixed to the belt, a rotatable roller adjacent to a lower edge connected to the side edge of the display panel and extending along the lower edge of the display panel, a light-shielding film having one end fixed to the bar and the other end coupled to the roller, and wound around or unwound from the roller when the bar moves, an upper pulley located above the side frame, the belt being wound around the upper pulley, and a driving pulley adjacent to the lower side of the side frame, facing the light-shielding film, and rotating about a thickness direction of the light-shielding film as an axis, the belt being wound around the driving pulley, wherein the bar includes a piece body on which the light-fielding film is wound, and a moving block moving relative to the piece body in the longitudinal direction of the side frame and coupled to the piece body, the belt is being fixed to the moving body.

### [Advantageous Effects]

The effects of the display device according to the present disclosure are described as follows.

According to at least one of embodiments of the present disclosure, a display device including a transparent display panel can be provided.

According to at least one of the embodiments of the present disclosure, a structure and a driving mechanism for opening and closing the rear surface of the transparent display panel can be provided.

According to at least one of the embodiments of the present disclosure, a frame structure in which the transparent display panel and a light-shielding film are combined can be provided.

According to at least one of the embodiments of the present disclosure, a driving mechanism for a film for light shielding of the transparent display panel can be provided.

According to at least one of the embodiments of the present disclosure, a structure capable of controlling the left-right balance of the light-shielding film can be provided.

According to at least one of the embodiments of the present disclosure, a structure capable of fine-tuning the initial position of the light-shielding film can be provided.

According to at least one of the embodiments of the present disclosure, a structure capable of providing uniform tension to the light-shielding film can be provided.

The additional scope of the applicability of the present disclosure will become apparent from the following detailed description. However, since various changes and modifications within the spirit and scope of the present disclosure are clearly understood by those skilled in the art, specific embodiments such as the detailed description and preferred embodiments of the present disclosure should be understood as being given merely as examples.

### [Description of Drawings]

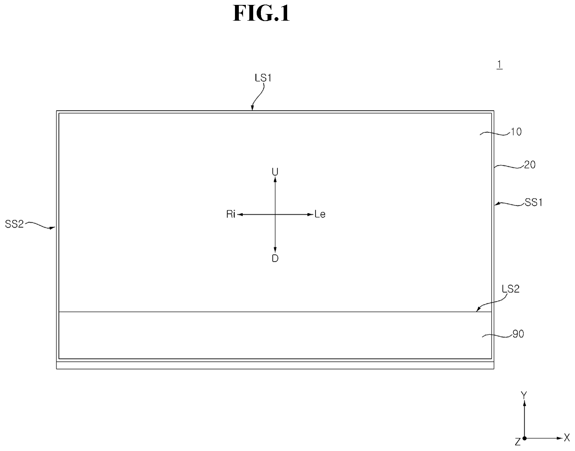

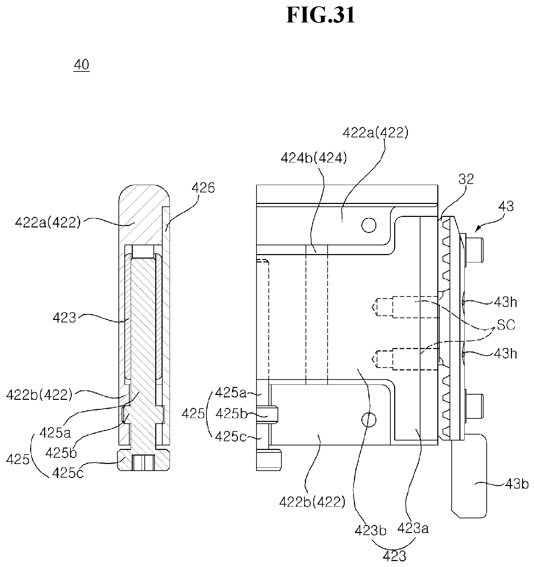

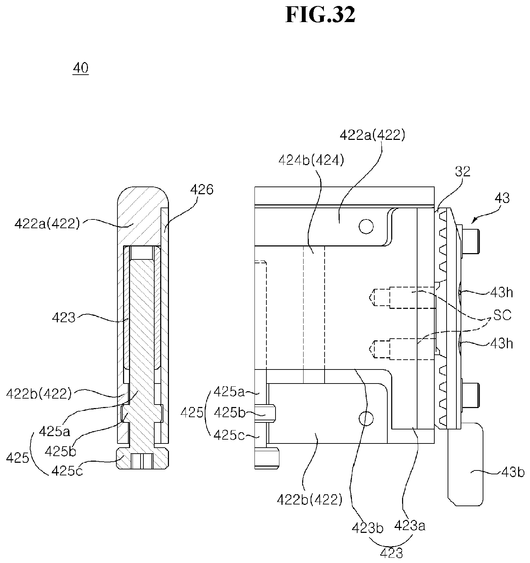

FIG. 1 to FIG. 33 are diagrams illustrating examples of display devices according to embodiments of the present disclosure.

### [Mode for Invention]

Hereinafter, embodiments of the present disclosure will be described in detail with reference to the attached drawings, and identical or similar components will be given the same reference numerals and redundant descriptions thereof will be omitted regardless of the drawing symbols.

The suffixes "module" and "unit" of elements herein are used for convenience of description and thus can be used interchangeably and do not have any distinguishable meanings or functions.

In the following description of embodiments of the present disclosure, a detailed description of known functions and configurations incorporated herein will be omitted when it may obscure the subject matter of the present disclosure. In addition, the attached drawings are only intended to facilitate easy understanding of the embodiments of the present disclosure, and the technical ideas disclosed in the present disclosure are not limited by the attached drawings and should be understood to include all modifications, equivalents, or substitutes included in the spirit and technical scope of the present disclosure.

Terms including ordinal numbers, such as first, second, etc., may be used to describe various components, but the components are not limited by the terms. The terms are used only to distinguish one component from another.

When a component is referred to as being "coupled" or "connected" to another component, it should be understood that the component may be directly coupled or connected to the other component but that there may be other components therebetween. On the other hand, when a component is referred to as being "directly coupled" or "directly connected" to another component, it should be understood that there are no other components therebetween.

The singular expression includes the plural expression unless the context clearly dictates otherwise.

In the present application, it will be understood that the terms "comprise" and "include" specify the presence of stated features, integers, steps, operations, elements, components, or combinations thereof, but do not preclude the presence or addition of one or more other features, integers, steps, operations, elements, components, or combinations thereof.

The directional indicators of Up (U), Down (D), Left (Le), Right (Ri), Front (F), and Back (R) shown in the drawings are for convenience of explanation only and do not limit the technical concept disclosed in this specification.

Referring to FIG. 1, a display device 1 may include a display 10, a side frame 20, and a housing 90. The display 10 can display an image. The side frame 20 may extend along the perimeter of the display 10. The housing 90 may be located below the display 10 and the side frame 20. Alternatively, the housing 90 may be located above, to the left, or below the display 10 and the side frame 20.

The display 10 may include a first long side LS1, a second long side LS2 opposite the first long side LS1, a first short side SS1 adjacent to the first long side LS1 and the second long side LS2, and a second short side SS2 opposite the first short side SS1.

Meanwhile, for the convenience of explanation, the lengths of the first and second long sides LS1 and LS2 are depicted and described as being greater than the lengths of the first and second short sides SS1 and SS2, but the lengths of the first and second long sides LS1 and LS2 may be approximately equal to or greater than the lengths of the first and second short sides SS1 and SS2.

The direction parallel to the long sides LS1 and LS2 of the display 10 may be referred to as a left-right direction. The direction parallel to the short sides SS1 and SS2 of the display 10 may be referred to as an up-down direction. The direction perpendicular to the long sides LS1 and LS2 and short sides SS1 and SS2 of the display 10 may be referred to as a front-back direction.

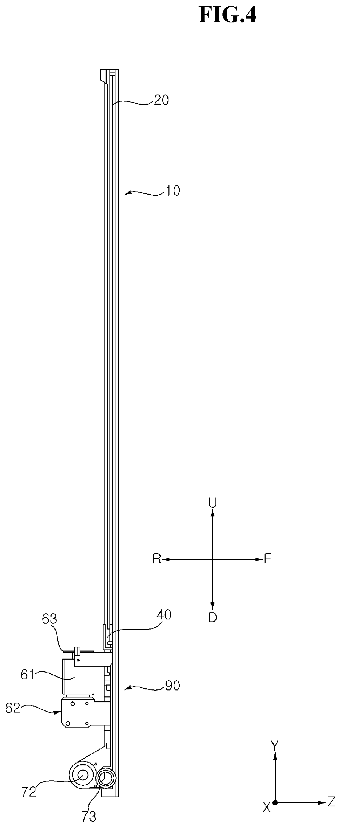

The direction in which the display 10 displays an image may be referred to as a front (F, z, refer to FIG. 4), and the opposite direction may be referred to as a rear (R, -z, refer to FIG. 4). The first short side SS1 may be referred to as a left (Le, x). The second short side SS2 may be referred to as a right (Ri, -x). The first long side LS1 may be referred to as a top (U, y). The second long side LS2 may be referred to as a bottom (D, -y).

Hereafter, a display panel using an organic light emitting diode (OLED) will be described as an example, but the display panel applicable to the present disclosure is not limited thereto.

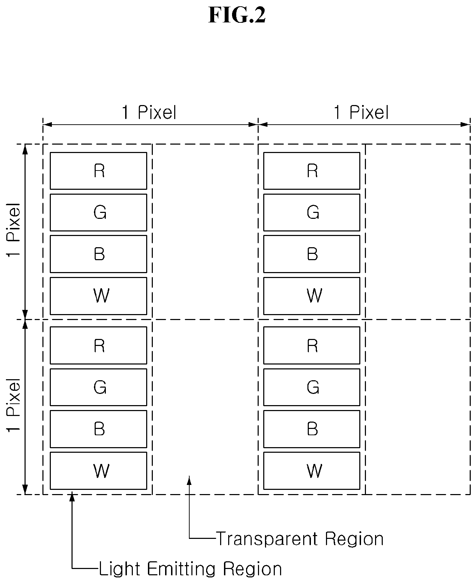

Referring to FIG. 2, a pixel may include a light emitting region and a transparent region. Subpixels RGBW (Red, Green, Blue, White) may be disposed in a vertical direction in the light emitting region, and the transparent region, which has no subpixels, may be disposed next to the light emitting region.

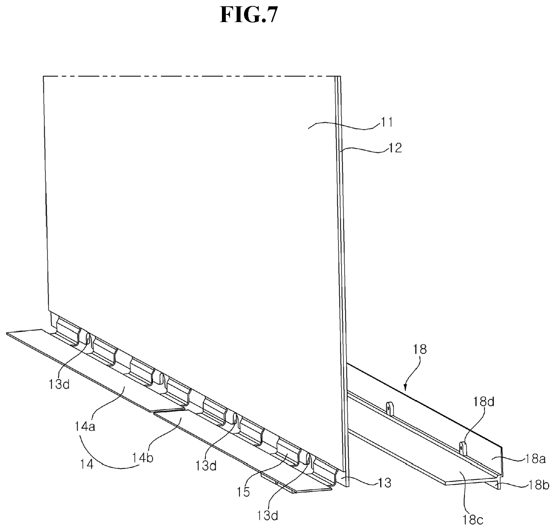

Accordingly, a display panel (11, refer to FIG. 7) having a plurality of pixels can not only display an image but also transmit light. The display panel (11, refer to FIG. 7) may be referred to as a transparent display panel or a transparent OLED panel.

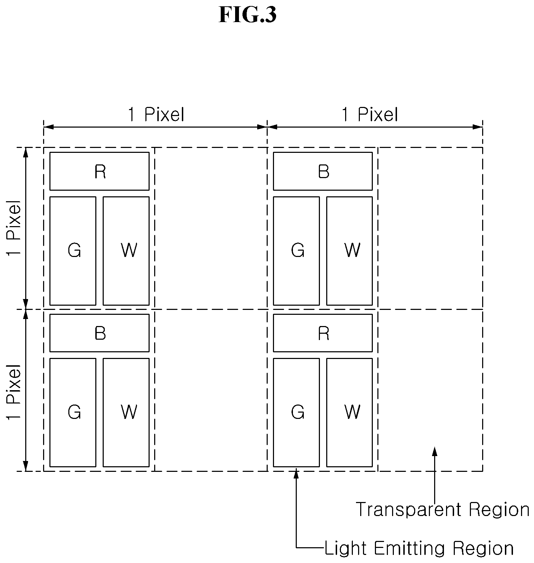

Referring to FIG. 3, a pixel may include a light emitting region and a transparent region. Subpixels RGW (Red, Green, White) or subpixels BGW (Blue, Green, White) may be disposed adjacent to each other in the light emitting region, and the transparent region, which has no subpixels, may be disposed next to the light emitting region.

Accordingly, the display panel (11, refer to FIG. 7) having multiple pixels can not only display an image but also transmit light. The display panel (11, refer to FIG. 7) may be referred to as a transparent display panel or a transparent OLED panel.

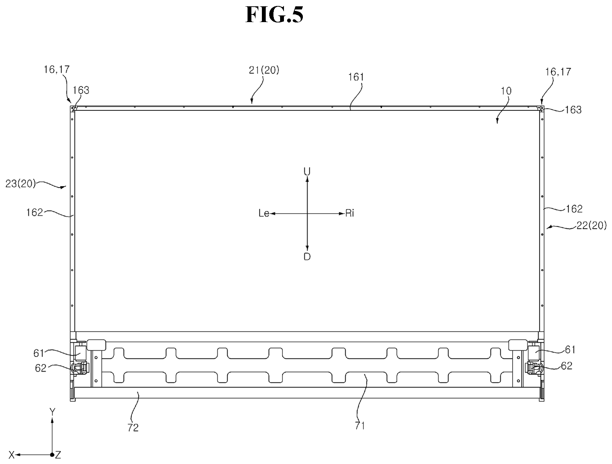

Referring to FIG. 4 and FIG. 5, the display 10 may be coupled to the side frame 20. A housing frame 71 may be coupled to or fixed to the side frame 20. The housing frame 71 may cover the rear of the display 10. The housing frame 71 may be located at the rear of the display 10. The housing frame 71 may be referred to as a rear frame 71, a rear plate 71, or a rear base 71. The length of the housing frame 71 may correspond to the length of the long sides of the display 10. The width of the housing frame 71 may be shorter than the length of the short sides of the display 10.

There may be multiple motors 61. The multiple motors 61 may be positioned at the rear of the display 10, adjacent to the left and right sides of the display 10. A pair of motors 61 may provide dual driving force. Gearboxes 62 may correspond to the motors 61. Each of the gearboxes 62 may be connected to each of the motors 61. A pair of gearboxes 62 may transmit the dual driving force provided by the pair of motors 61. The motors 61 and/or the gearboxes 62 may be attached to or fixed to the rear of the housing frame 71. The motors 61 and/or the gearboxes 62 may not be exposed to the front of the display device 10 by the housing frame 71. A bar 40 may move up and down while sliding on the side frame 20.

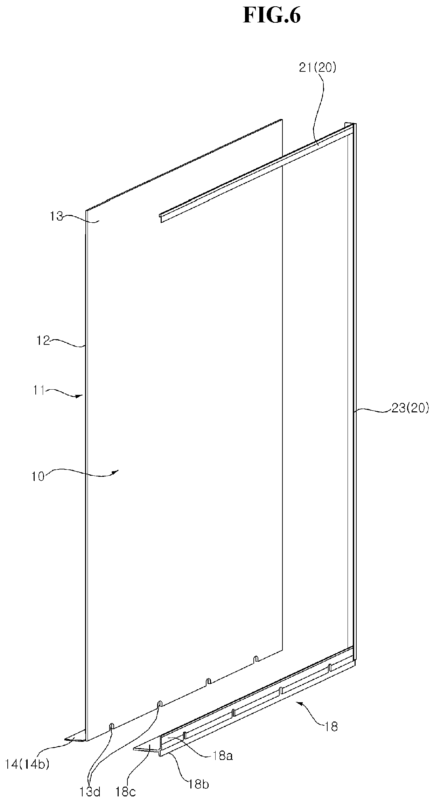

Referring to FIG. 6 together with FIG. 5, the display 10 may be coupled to the side frame 20. A lower frame 18 may be coupled to or fixed to the side frame 20 and may support the display 10 from the lower side of the display 10. The side frame 20 may include a first part 21, a second part 22, and a third part 23.

The first part 21 may be coupled to the upper side of the display 10, the second part 22 may be coupled to the right side of the display 10, and the third part 23 may be coupled to the left side of the display 10. The lower frame 18 may be coupled to or fixed to the second part 22 and/or the third part 23 of the side frame 20.

Vertical fixers 162 may be coupled to the second part 22 and the third part 23, and a horizontal fixer 161 may be coupled to the first part 21. Corner fixers 16 and pulleys 17 may be coupled to the vertical fixers 161 and/or the horizontal fixer 162 at the upper corners.

Referring to FIG. 7 together with FIG. 6, the display panel 11 may display an image by dividing the image into multiple pixels and matching the color, brightness, and saturation for each pixel. The display panel 11 may be divided into an active area AA where an image is displayed and a de-active area DA where no image is displayed. The display panel 11 may generate light corresponding to red (R), green (G), or blue (B) according to a control signal.

A source PCB 14 may be adjacent to the lower edge of the display panel 11. The source PCB 14 may extend along the lower edge of the display panel 11. The source PCB 14 may be electrically connected to the display panel 11 via a chip on film (COF) 15. The source PCB 14 may be electrically connected to a timing controller (T-CON) board via a cable (not shown), such as a flexible flat cable (FFC).

A transparent panel 13 may be located in front of the display panel 11. The transparent panel 13 may be made of transparent glass. An adhesive film 12 may be located between the display panel 11 and the transparent panel 13 and may be bonded to the display panel 11 and the transparent panel 13. The adhesive film 12 may be an optically clear adhesive film (OCA). The transparent panel 13 may be referred to as a front panel 13.

The adhesive film 12 may cover at least a portion of the rear surface of the transparent panel 13. For example, one side of the adhesive film 12 may be located closer to the center of the display panel 11 than a side of the transparent panel 13 corresponding thereto. The size or area of the adhesive film 12 may be less than the size or area of the transparent panel 13. For example, the upper side, left side, and right side of the adhesive film 12 may be adjacent to the upper side, left side, and right side of the transparent panel 13, and the lower side of the adhesive film 12 may be spaced upward from the lower side of the transparent panel 13.

The size of the adhesive film 12 may correspond to the size of the display panel 11. For example, the diagonal length of the adhesive film 12 may be substantially the same as the diagonal length of the display panel 11. As another example, the diagonal length of the adhesive film 12 may be greater than the diagonal length of the display panel 11. A portion of the adhesive film 12 may be disposed along the perimeter of the display panel 11 on the outside of the display panel 11. For example, the adhesive film 12 may form a rectangular line along the perimeter of the display panel 11.

The display panel 11, the adhesive film 12, and the transparent panel 13 may be referred to as the display 10.

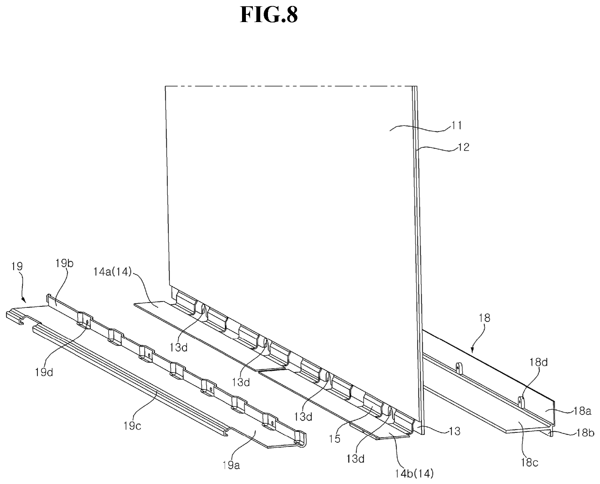

Referring to FIG. 8 together with FIG. 7, the lower frame 18 may include a horizontal portion 18c, a first vertical portion 18a, a second vertical portion 18b, and a coupling portion 18d. The horizontal portion 18c may be a long extended plate, and the first vertical portion 18a may extend upward from the front edge of the horizontal portion 18c to form a right angle with the horizontal portion 18c. The second vertical portion 18b may extend downward from the front edge of the horizontal portion 18c to form a right angle with the horizontal portion 18c. The coupling portion 18d may protrude from the rear surface of the first vertical portion 18a. The coupling portion 18d may be formed on the upper surface of the horizontal portion 18c and/or on the rear surface of the first vertical portion 18a. A plurality of coupling portions 18d may be disposed at regular intervals.

The transparent panel 13 may include coupling grooves 13d in which portions are removed from the lower edge. The coupling grooves 13d of the transparent panel 13 may correspond to the coupling portions 18d of the lower frame 18. The coupling portions 18d of the lower frame 18 may be inserted into the coupling grooves 13d of the transparent panel 13. The first vertical portion 18a may cover the front surface of the transparent panel 13 adjacent to the lower edge of the transparent panel 13. The horizontal portion 18c of the lower frame 18 may support the transparent panel 13.

The source PCB 14 may be positioned on the horizontal portion 18c of the lower frame 18. The source PCB 14 may face or contact the horizontal portion 18c of the lower frame 18.

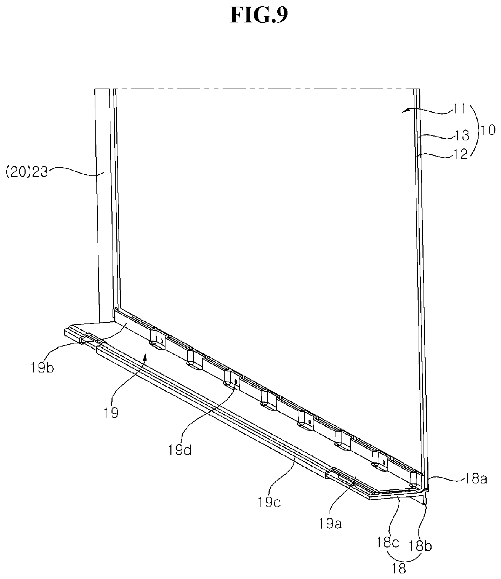

Referring to FIG. 9 together with FIG. 8, a PCB cover 19 may include a horizontal portion 19a, a folding portion 19c, a vertical portion 19b, and a fixed portion 19d. The horizontal portion 19a may be an elongated plate and may cover the source PCB 14. The vertical portion 19b may be formed by extending upward from the edge of the horizontal portion 19a or by bending. The folding portion 19c may face the vertical portion 19b with respect to the horizontal portion 19a. The folding portion 19c may extend from the horizontal portion 19a while bending toward the lower surface of the horizontal portion 19a. The folding portion 19c may face the horizontal portion 19a. The fixed portion 19d may be formed on the vertical portion 19b. The fixed portion 19d may be formed by protruding forward from the vertical portion 19b as the vertical portion 19b is pressed. The fixed portion 19d may be fixed to the coupling portion 18d of the lower frame 18.

The folding portion 19c of the PCB cover 19 is coupled to the horizontal portion 18c of the lower frame 18, and when the fixed portion 19d of the PCB cover 19 is fixed to the coupling portion 18d of the lower frame 18, the PCB cover 19 can cover the source PCB 14.

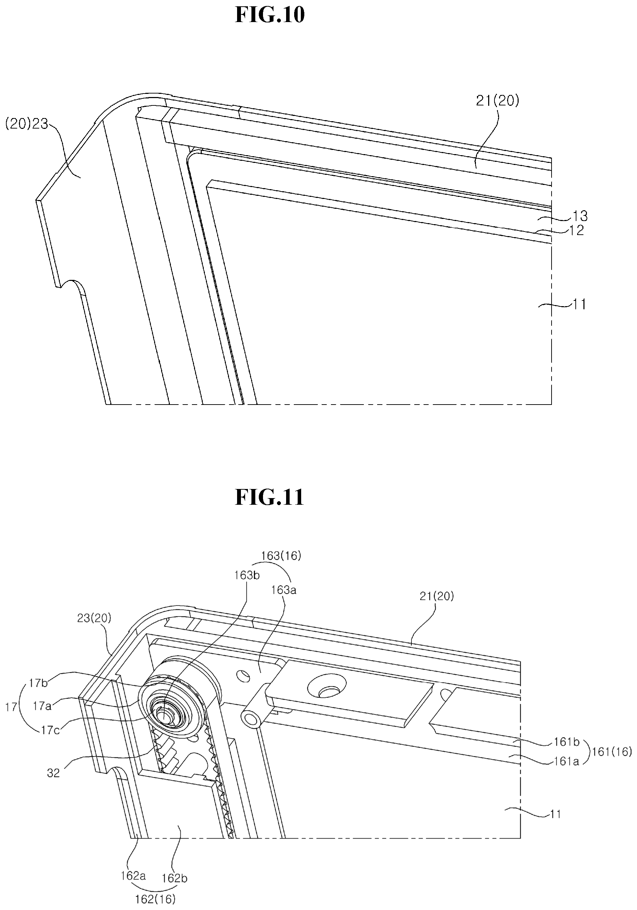

Referring to FIG. 10 and FIG. 11, the display panel 11 may be disposed on the rear of the transparent panel 13. The display panel 11 may be attached to or fixed to the adhesive film 12.

A frame fixer 16 may include the horizontal fixer 161, the vertical fixer 162, and the corner fixer 163. The horizontal fixer 161 may be integrated with the vertical fixer 162. The horizontal fixer 161 and the vertical fixer 162 may be referred to as an inner frame 161 and 162. The horizontal fixer 161 may include a plate 161a and a wall 161b. The plate 161a extends horizontally and may be fixed to the first part 21 of the side frame 20. The wall 161b may be formed on the plate 161a. The wall 161b may protrude rearward from the outer surface of the plate 161a.

The vertical fixer 162 may include a plate 162a and a wall 162b. The plate 162a may extend vertically and may be fixed to the third part 23 of the side frame 20. The wall 162b may be formed on the plate 162a. The wall 162b may protrude in the left-right direction from the outer surface of the plate 162a.

The corner fixer 163 may be a curved plate segment. The corner fixer 163 may be a plate 163a curved along the corner of the vertical fixer 162 and the horizontal fixer 161. A pulley shaft 163b may extend outward from the outer surface of the plate 163a of the corner fixer 163 toward the rear of the transparent panel 13. The corner fixer 163 may be attached to or fixed to the horizontal fixer 161 and/or the vertical fixer 162. The corner fixer 163 may be referred to as a left corner fixer 163 or a first corner fixer 163. When the corner fixer 163 is located at the corner formed by the first part 21 and the second part 22 of the side frame 20 (refer to FIG. 5), the corner fixer 163 may be referred to as a right corner fixer 163 or a second corner fixer 163.

The pulley shaft 163b may be inserted into the pulley 17. The pulley 17 can rotate on the pulley shaft 163b. The pulley 17 may be referred to as an upper pulley 17. For example, a lubricant for noise prevention may be applied between the pulley shaft 163b and the pulley 17. As another example, the pulley 17 may be formed of a synthetic resin having low friction resistance, and the pulley shaft 163b may include a metal to prevent noise and make the rotation of the pulley 17 smooth. A belt 32 may be wound around the pulley 17.

The pulley 17 may include a wheel 17a and a belt gear 17b. The wheel 17a may be formed in a ring or rim shape. The pulley shaft 163b may be inserted into the wheel 17a, and the wheel 17a may rotate on the pulley shaft 163b. The belt gear 17b can form the outer surface of the wheel 17a. A fixing washer 17c may be coupled to the pulley shaft 163b adjacent to the end of the pulley shaft 163b. For example, the fixing washer 17c may be an E-ring. The fixing washer 17c can prevent the pulley 17 from being separated from the pulley shaft 163b. The first pulley 17 or the left pulley 17 may be located on the first corner fixer 163 or the left corner fixer 163, and the second pulley (17, refer to FIG. 5) or the right pulley (17, refer to FIG. 5) may be located on the second corner fixer 163 or the right corner fixer 163.

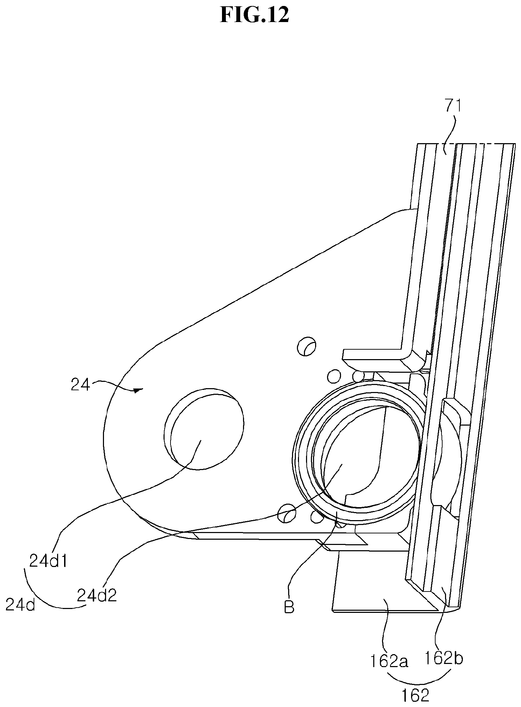

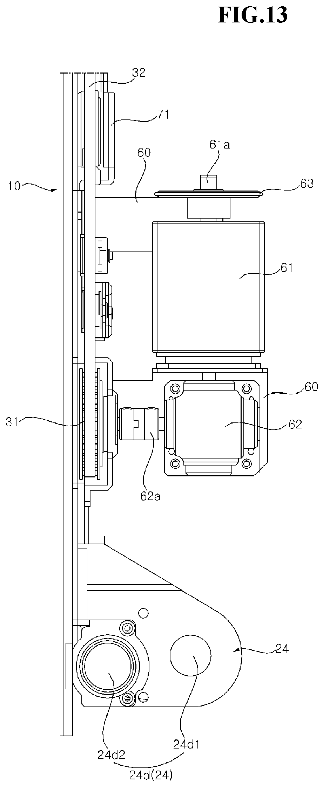

Referring to FIG. 12 and FIG. 13, a mount bracket 24 may be coupled to or fixed to the plate 162a of the vertical fixer 162 and may be supported on the wall 162b of the vertical fixer 162. The mount bracket 24 may be coupled to or fixed to the wall 162b of the vertical fixer 162 and may be supported on the plate 162a of the vertical fixer 162.

The mount bracket 24 may include a main roller hole 24d1 and a sub-roller hole 24d2. The sub-roller hole 24d2 may face or overlap the plate 162a of the vertical fixer 162. The main roller hole 24d1 may be adjacent to the sub-roller hole 24d2. A bearing B may be mounted in the main roller hole 24d1 and/or the sub-roller hole 24d2.

A fixed bracket 60 may be coupled to the vertical fixer 162 or to the housing frame 71. The fixed bracket 60 may also be integrated with the housing frame 71. The motor 61 and/or the gearbox 62 may be coupled to the fixed bracket 60. The motor 61 can provide rotational force, and the gearbox 62 may be connected to the motor 61 to transmit driving force. A rotary counter 63 is fixed to a motor shaft 61a and can rotate together with the motor shaft 61a.

A joint 62a is connected to the gearbox 62 and can rotate by receiving driving force from the gearbox 62. The axial direction of the joint 62a may be parallel to the thickness direction of the display 10. A driving pulley 31 is fixed to the joint 62a and can rotate together with the joint 62a. The belt 32 may be wound around the driving pulley 31. The belt 32 may be referred to as a drive belt 32 or a timing belt 32. The driving pulley 31 may be referred to as a lower pulley 31, a main pulley 31, or a suspending pulley 31.

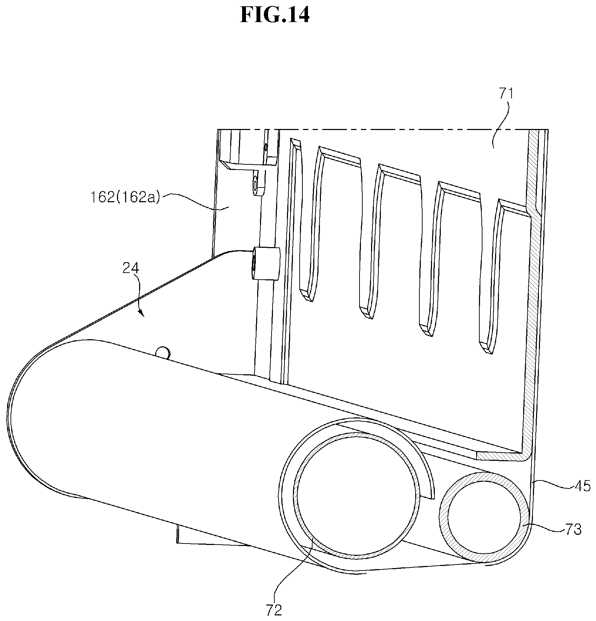

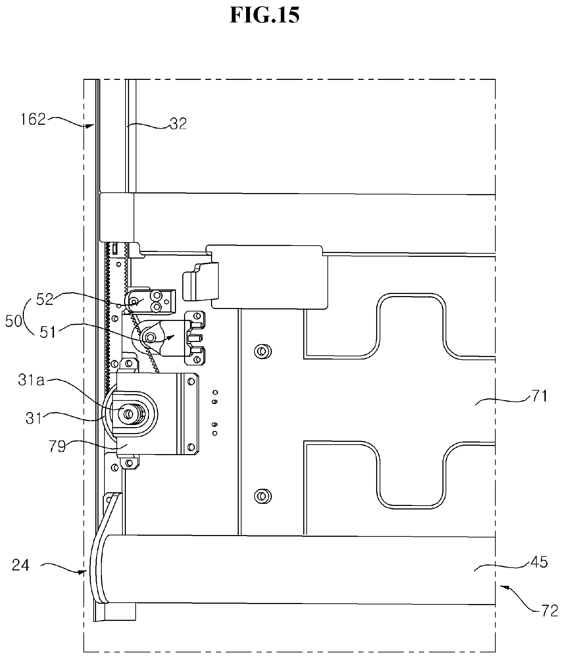

Referring to FIG. 14 and FIG. 15, a main roller 72 can rotate by being coupled to or inserted into the main roller hole (24d1, refer to FIG. 13) of the mount bracket 24. A sub-roller 73 can rotate by being coupled to or inserted into the sub-roller hole (24d2, refer to FIG. 13) of the mount bracket 24. A light-shielding film 45 may be wound onto the main roller 72 and supported by the sub-roller 73. As the light-shielding film 45 is unwound from the main roller 72, the light-shielding film 45 can be guided by the sub-roller 73 and moved to the front of the housing frame 71. The light-shielding film 45 unwound from the main roller 72 can cover the front of the housing frame 71.

A pulley mount 79 may be coupled to the rear of the housing frame 71. The pulley mount 79 may be a bracket or a plate. The pulley mount 79 may be integrated with the housing frame 71. The driving pulley 31 may rotate on the pulley mount 79. A shaft 31a of the driving pulley 31 is inserted into the pulley mount 79 and the position thereof may be aligned by the pulley mount 79. For example, the driving pulley 31 can rotate on the pulley mount 79 but cannot move up and down or to the left and right.

A sub-pulley 50 may be a tensioner 50. The sub-pulley 50 is located on the upper side of the pulley mount 79 and can push the belt 32. The belt 32 can maintain constant tension by the sub-pulley 50. There may be multiple sub-pulleys 51 and 52.

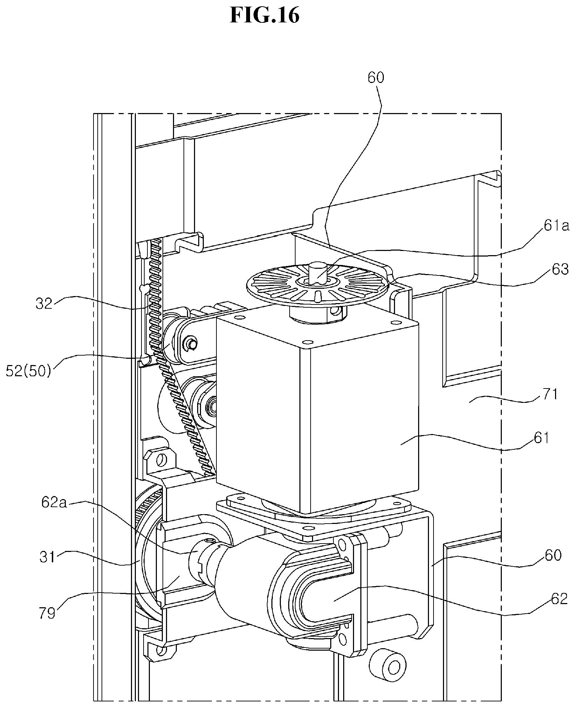

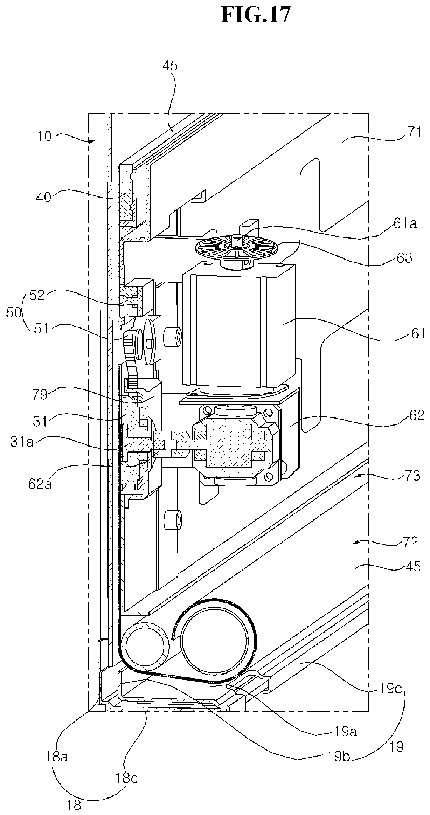

Referring to FIG. 16 and FIG. 17 together with FIG. 15, the driving force provided by the motor 61 may be transmitted to the driving pulley 31 through the gearbox 62. The driving pulley 31 can rotate on the pulley mount 79. As the driving pulley 31 rotates, the belt 32 moves up and down, and the belt 32 can maintain a constant tension by the sub-pulley 50.

The lower frame 18 to which the PCB cover 19 is coupled may be located under the housing frame 71. The main roller 72 and the sub-roller 73 are located on the lower frame 18 and may be located at the rear of the housing frame 71. The light-shielding film 45 may be wound around and unwound from the main roller 72 and guided by the sub-roller 73 to cover the front of the housing frame 71.

The end of the light-shielding film 45 may be fixed to the bar 40. As the belt 32 fixed to one end of the bar 40 moves, the bar 40 can move up and down. As the bar 40 moves, the light-shielding film 45 can cover the rear of the display 10. The bar 40 is located at the rear of the rear of the display 10 and can move in the up-down direction of the display 10.

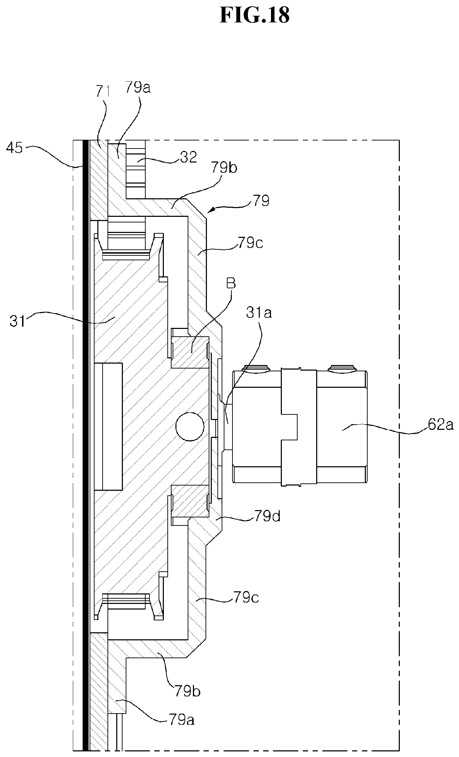

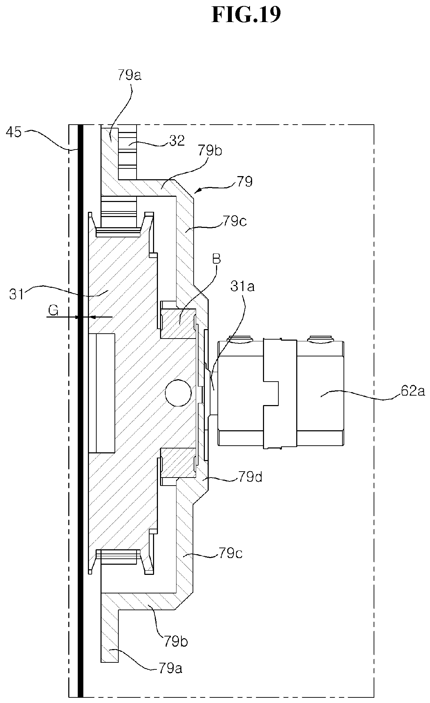

Referring to FIG. 18 and FIG. 19, the pulley mount 79 may include a flange portion 79a, a pulley housing 79b, a bearing mount 79c, and a shaft mount 79d. The flange portion 79a has a disc shape and may be fixed to the rear of the housing frame 71. The pulley housing 79b may provide a space for accommodating the driving pulley 31. The diameter of the pulley housing 79b may be larger than the diameter of the driving pulley 31, and the height of the pulley housing 79b may be greater than the thickness of the driving pulley 31.

The bearing B may be fixed to the bearing mount 79c. The pulley shaft 31a may pass through the shaft mount 79d from the inside to the outside of the pulley mount 79. The driving pulley 31 may be coupled to the bearing B and rotate inside the pulley housing 79b. The pulley shaft 31a may be coupled to the joint 62a and rotate together with the joint 62a.

The front of the driving pulley 31 may be spaced apart from the light-shielding film 45. A certain gap G may be formed between the front of the driving pulley 31 and the rear of the light-shielding film 45. Accordingly, the driving pulley 31 can rotate and move the belt 32 without a structure penetrating the light-shielding film 45.

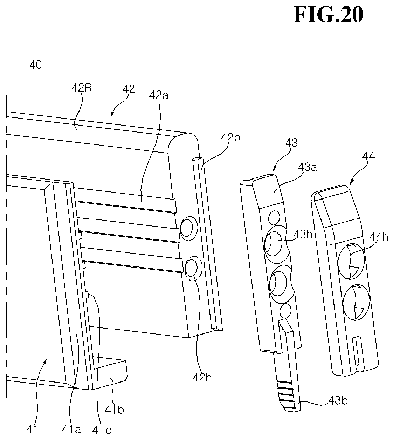

Referring to FIG. 20, the bar 40 may include a first piece 41, a second piece 42, a belt fixer 43, and a fixer cover 44. The first piece 41 may be combined with the second piece 42. The first piece 41 may include a first part 41a and a second part 41b. The first part 41a may have the shape of an elongated plate bar. The second part 41b may extend in the thickness direction of the first part 41a and form a wall at the edge of the first part 41a. A fixing rib 41c may be formed on one side of the first part 41a. The fixing rib 41c may extend in the longitudinal direction of the first part 41a. There may be multiple fixing ribs 41c. The multiple fixing ribs 41c may be spaced apart from each other at a certain distance.

The second piece 42 may have the shape of a plate bar extending to a length corresponding to the first part 41a of the first piece 41. A rib groove 42a may be formed on one side of the second piece 42 and extends long in the longitudinal direction of the second piece 42. There may be multiple rib grooves 42a, and the multiple rib grooves 42a may be disposed on one side of the second piece 42a corresponding to the multiple fixing ribs 41c. A side rib 42b may be formed on the end surface of the second piece 42 in the width direction of the second piece 42. A fastening hole 42h may be formed adjacent to the side rib 42b on the end surface of the second piece 42. There may be multiple fastening holes 42h. An edge 42R of the second piece 42 may be rounded in the longitudinal direction of the second piece 42.

The belt fixer 43 may be coupled to the end surfaces of the first piece 41 and the second piece 42. The belt fixer 43 may include a fastening hole 43h. The fastening hole 43h of the belt fixer 43 may correspond to the fastening hole 42h of the second piece 42. There may be multiple fastening holes 43h.

The fixer cover 44 may be coupled to the belt fixer 43. The fixer cover 44 may have an insertion hole 44h. The insertion hole 44h may correspond to the fastening hole 43h of the belt fixer 43. There may be multiple insertion holes 44h.

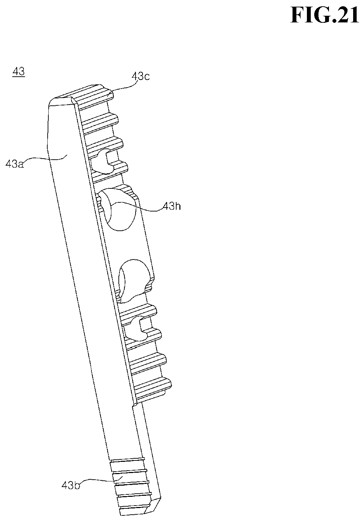

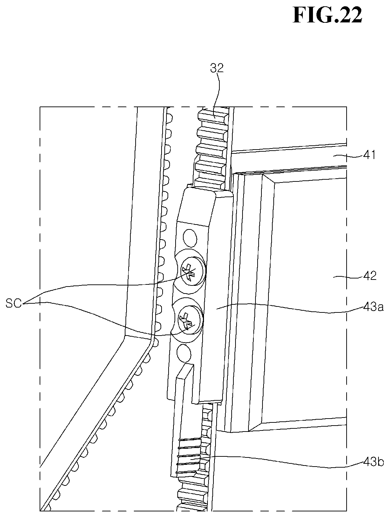

Referring to FIG. 21 and FIG. 22, the belt fixer 43 may include a fixer body 43a and a fixer tail 43b. The fixer body 43a may extend and may have fastening holes 43h. A gear surface 43c may be formed on one side of the fixer body 43a. The fixer tail 43b may extend from one end of the fixer body 43a in the longitudinal direction of the fixer body 43a. The fixer tail 43b may be an indicator of the position of the bar (40, refer to FIG. 20).

The belt fixer 43 may press against the belt 32 and be coupled to one end of the bar 40. The gear of the belt 32 and the gear surface 43c of the belt fixer 43 may be engaged with each other. A screw SC may be inserted into the fastening hole 43h to secure the belt fixer 43 to one end of the bar (40, refer to FIG. 20). Accordingly, slippage of the belt 32 can be prevented, and the precise vertical movement of the bar (40, refer to FIG. 20) can be achieved.

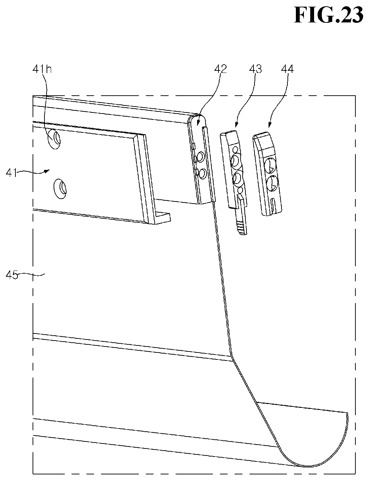

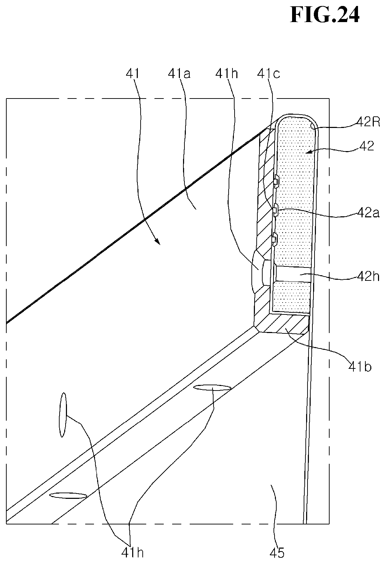

Referring to FIG. 23 and FIG. 24, the light-shielding film 45 may be wound around the bar 40. The light-shielding film 45 may cover the outer surface of the second piece 42, wrap around a rounded edge 42R, and be inserted between the first piece 41 and the second piece 42. The light-shielding film 45 may come into contact with the first piece 41 and the second piece 42. The light-shielding film 45 may be positioned between the fixing rib 41c and the rib groove 42a. The fixing rib 41c may hold the light-shielding film 45 while being inserted into the rib groove 42a. The light-shielding film 45 can be provided with tension while being wound around the edge 42R of the rounded second piece 42.

The end of the light-shielding film 45 may be located between the first part 41a of the first piece 41 and the second piece 42. The end of the light-shielding film 45 may also be located between the second part 41b of the first piece 41 and the second piece 42. When the end of the light-shielding film 45 is located between the second part 41b of the first piece 41 and the second piece 42, the light-shielding film 45 can be more firmly fixed to the bar 40.

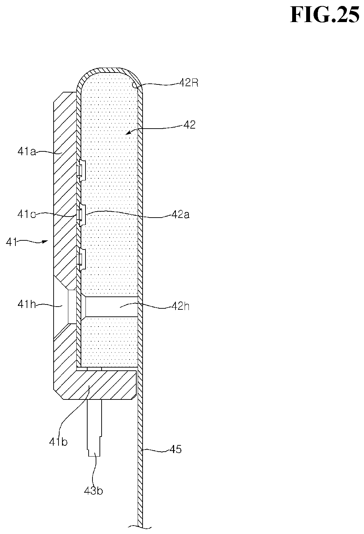

Referring to FIG. 25 together with FIG. 24, the second piece 42 may include a horizontal fastening hole 42h. The horizontal fastening hole 42h may be formed by penetrating the second piece 42 in the thickness direction of the second piece 42. The first part 41a of the first piece 41 may include a horizontal fastening hole 41h. The horizontal fastening hole 41h of the first piece 41 may correspond to the horizontal fastening hole 42h of the second piece 42. A fastening member may be fixed by being inserted into the horizontal fastening hole 42h of the second piece 42 through the horizontal fastening hole 41h of the first piece 41. At this time, the fastening member may penetrate the light-shielding film 45. As the screw penetrates the light-shielding film 45, wrinkles may form in the light-shielding film 45. The fixing rib 41c can block the wrinkles in the light-shielding film 45 as it is inserted into the rib groove 42a.

Accordingly, the light-shielding film 45 can receive sufficient tension by being firmly fixed to the bar 40, and can be prevented from wrinkling.

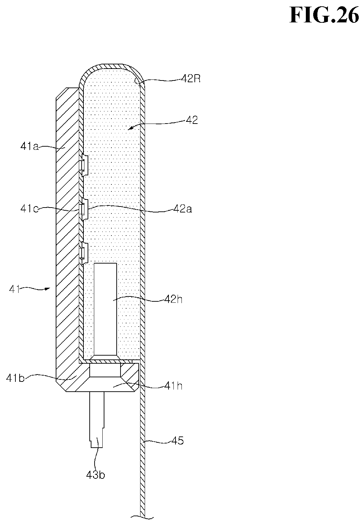

Referring to FIG. 26 together with FIG. 24, the second piece 42 may include a vertical fastening hole 42h. The vertical fastening hole 42h may be formed into the inside of the second piece 42 in the width direction of the second piece 42. The second part 41b of the first piece 41 may include a vertical fastening hole 41h. The vertical fastening hole 41h of the first piece 41 may correspond to the vertical fastening hole 42h of the second piece 42. A fastening member may be fixed by being inserted into the vertical fastening hole 42h of the second piece 42 through the vertical fastening hole 41h of the first piece 41h. At this time, the fastening member can penetrate the light-shielding film 45. As the screw penetrates the light-shielding film 45, wrinkles may form in the light-shielding film 45. The wrinkles in the light-shielding film 45 can be blocked as the fixing rib 41c is inserted into the rib groove 42a.

Accordingly, the light-shielding film 45 can receive sufficient tension by being firmly fixed to the bar 40, and can be prevented from wrinkling.

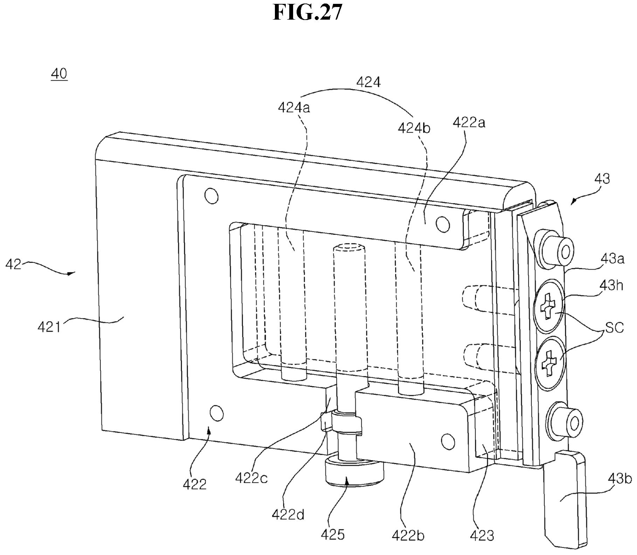

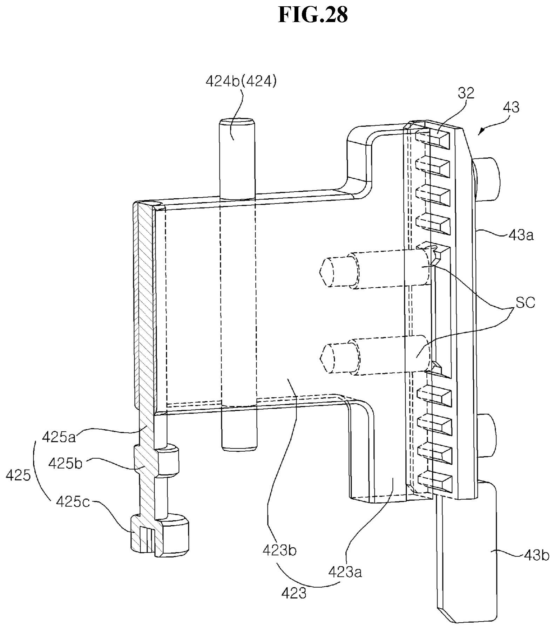

Referring to FIG. 27 and FIG. 28, the second piece 42 of the bar 40 may include a piece body 421 and 422 and a moving block 423. The piece body 421 and 422 may include a main body 421 and a side body 422. The main body 421 may extend in the left-right direction LR of the display device (1, refer to FIG. 1). The side body 422 may be formed on both sides of the main body 421. The side body 422 may include an upper part 422a and a lower part 422b formed by removing a portion of the side body 422 in the longitudinal direction of the main body 421.

There may be a plurality of block guide shafts 424. The first block guide shaft 424a may connect the upper part 422a and the lower part 422b in a direction intersecting the longitudinal direction of the main body 421. The second block guide shaft 424b is positioned parallel to the first block guide shaft 424a and may connect the upper part 422a and the lower part 422b.

A leveling shaft 425 may be positioned between the first block guide shaft 424a and the second block guide shaft 424b. The leveling shaft 425 may be rotatably coupled to the lower part 422b. The leveling shaft 425 may be positioned parallel to the first block guide shaft 424a and/or the second block guide shaft 424b.

The moving block 423 may include an inner part 423b and an outer part 423a. The inner part 423b may be inserted between the upper part 422a and the lower part 422b of the side body 422. The inner part 423b may extend in the longitudinal direction of the piece body 421 and have a length corresponding to the length of the upper part 422a and/or the lower part 422b. The width of the inner part 423b may be less than the gap between the upper part 422a and the lower part 422b. The inner part 423b may move between the upper part 422a and the lower part 422b. The first block guide shaft 424a and/or the second block guide shaft 424b may be inserted into the inner part 423b of the moving block 423. The moving block 423 may move in the longitudinal direction of the first block guide shaft 424a and/or the second block guide shaft 424b between the upper part 422a and the lower part 422b of the side body 422.

The outer part 423a may be connected to the inner part 423b. The outer part 423a may be integrated with the inner part 423b. The outer part 423a may also be coupled to the inner part 423b. The moving block 423 may be T-shaped overall. The belt fixer 43 may be coupled to or fixed to the outer part 423a of the moving block 423. The belt 32 is positioned between the outer part 423a and the belt fixer 43 and may be fixed to the moving block 423 as the belt fixer 43 is coupled to or fixed to the outer part 423a of the moving block 423 by a fastening member SC. As the fastening member SC rotates, the belt fixer 32 may press or compress the belt 32 against the outer part 423a of the moving block 423.

The leveling shaft 425 may include a shaft 425a, a rim 425b, and a head 425c. The shaft 425a may be a long, extended pipe. The head 425c may be formed at the end of the shaft 425a, and the rim 425b may be positioned closer to the head 425c than to the end of the shaft 425a, protrude from the outer surface of the shaft 425a, and have a diameter larger than the diameter of the shaft 425a. The shaft 425a may be screw-coupled to the inner part 423b of the moving block 423.

A leveling hole 422c may be formed in the lower part 422b. The leveling hole 422c may be formed by penetrating the lower part 422b from the lower part 422b toward the upper part 422a. A rim groove 422d may be formed in the leveling hole 422c. The rim groove 422d may be formed by the inner surface of the leveling hole 422c being recessed or cut out.

The shaft 425a of the leveling shaft 425 may be screw-coupled to the inner part 423b of the moving block 423 through the leveling hole 422c. The rim 425b of the leveling shaft 425 may be inserted into the rim groove 422d of the leveling hole 422c. The head 425c of the leveling shaft 425 may be exposed from the lower side of the side body 422 to the outside of the side body 422. When the head 425c is rotated, the leveling shaft 425 rotates, and the moving block 423 can move in the up-down direction.

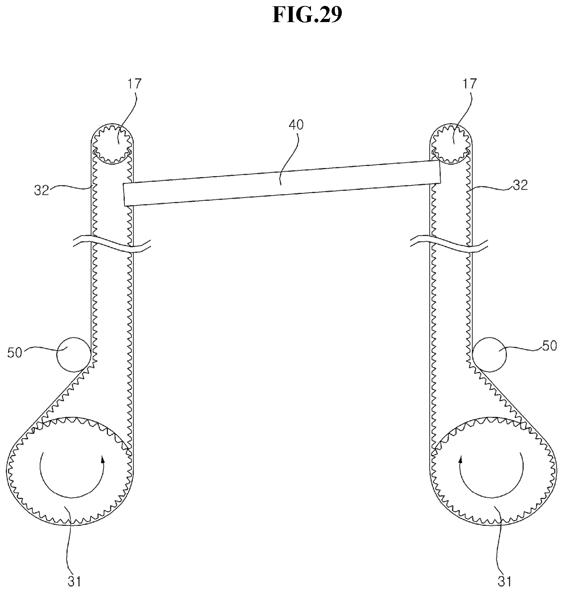

Referring to FIG. 29, both ends of the bar 40 may be fixed to the belt 32. The left belt 32 may be wound around the left upper pulley 17 and the left driving pulley 31. When the left driving pulley 31 rotates, the left belt 32 can move the left side of the bar 40 up and down. The right belt 32 may be wound around the right upper pulley 17 and the right driving pulley 31. When the right driving pulley 17 rotates, the right belt 32 can move the right side of the bar 40 up and down.

As the bar 40 moves up and down, the horizontal alignment of the bar 40 may not be secured. Further, when initially setting the horizontal alignment of the bar 40, it may be difficult to align the bar 40 horizontally due to the tolerance or clearance of the drive mechanism of the belt 32. If the horizontal alignment of the bar 40 is not secured, the light-shielding film (45, refer to FIG. 17) cannot be kept flat. If the light-shielding film 45 is not kept flat, a part thereof may come into contact with the display panel (11, refer to FIG. 10) and/or the transparent panel 13, and static electricity generated by friction between the light-shielding film 45 and the display panel 11 and/or the transparent panel 13 may adversely affect the performance of the display device.

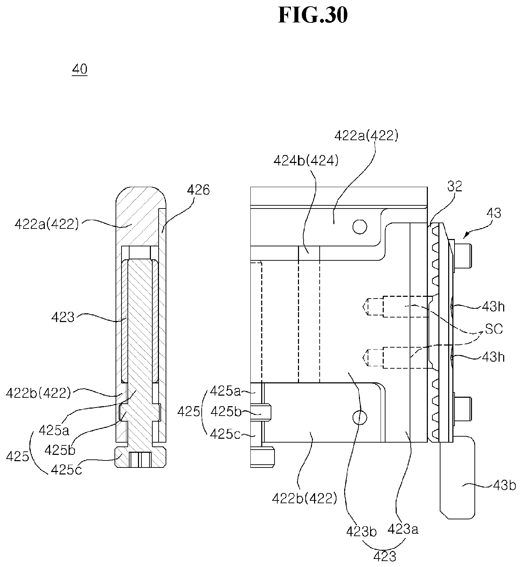

Referring to FIG. 30 to FIG. 32, as the leveling shaft 425 rotates, the moving block 423 moves up and down on the side body 422, and the belt 32 and the belt fixer 43 can move up and down relative to the piece body (421 and 422, refer to FIG. 27) of the bar 40. A block cover 426 is coupled to the side body 422 and can cover the moving block 423.

The moving block 423 may be in contact with or supported by the lower part 422b of the side body 422. The moving block 423 may move upward by the rotation of the leveling shaft 425. As the moving block 423 is released from contact with the lower part 422b of the side body 422 and moves upward, the block guide shaft 425 can restrict the direction of movement of the moving block 423. By means of the block guide shaft 425, the moving block 423 can move from the lower part 422b of the side body 422 to the upper part 422a.

When the moving block 423 is supported by or contacts the upper part 422a of the side body 422 by the rotation of the leveling shaft 425, the leveling shaft 425 may no longer rotate. The relative movement of the belt 32 and belt fixer 43 with respect to the side body 422 may be terminated.

Accordingly, the moving block 423 located on both sides of the bar 40 can move up and down relative to the side body 422 of the bar 40 to finely adjust the position of the bar 40 relative to the belt 32 and the belt fixer 43 and to ensure the horizontal alignment of the bar 40.

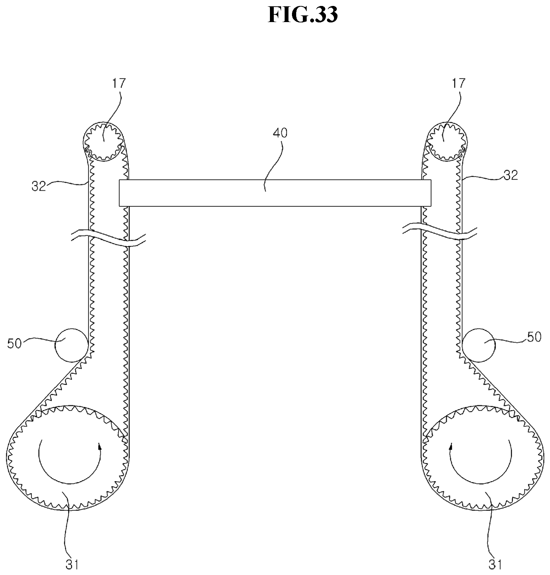

Referring to FIG. 33 together with FIG. 17, when the bar 40 moves up and down by the belt 32 while the horizontal alignment of the bar 40 is secured, the light-shielding film (45, refer to FIG. 17 and FIG. 18) can maintain a flat state. The light-shielding film 45 maintaining a flat state can cover or open the display panel 11 behind the display panel 11 while maintaining a gap, without contacting the display panel 11 and/or the transparent panel 13.

Referring to FIG. 1 to FIG. 33, a display device includes: a display panel which displays an image and is transparent; a transparent panel facing the display panel; a side frame which extends along the side edge of the display panel and is coupled to the transparent panel; a belt which is provided in the side frame and moves in the longitudinal direction of the side frame; a bar which extends in a direction intersecting the side frame and has one end fixed to the belt; a rotatable roller which is adjacent to the lower edge connected to the side edge of the display panel and extends along the lower edge of the display panel; a light-shielding film which has one end fixed to the bar and the other end coupled to the roller, and is wound around or unwound from the roller when the bar moves; an upper pulley located above the side frame and around which the belt is wound; and a driving pulley which is adjacent to the lower side of the side frame, faces the light-shielding film, rotates about the thickness direction of the light-shielding film as an axis, and around which the belt is wound, wherein the bar includes: a piece body on which the light-fielding film is wound; and a moving block which moves relative to the piece body in the longitudinal direction of the side frame, is coupled to the piece body, and to which the belt is fixed.

The piece body may include: a main body extending in the longitudinal direction of the bar; and a side body formed at the end of the main body and having an upper part and a lower part formed by removing the center of the side body in the longitudinal direction of the main body from the belt toward the main body, and the moving block may be inserted between the upper part and the lower part of the side body and move between the upper part and the lower part.

The side body may include a block guide shaft which is parallel to the side frame, connects the upper part and the lower part, and is inserted into the moving block, and the moving block may be spaced apart from the upper part when supported on or in contact with the lower part, and spaced apart from the lower part when supported on or in contact with the upper part.

The display device may further include a belt fixer for securing the belt to the moving block.

The bar may further include a leveling shaft rotatably coupled to the lower part of the side body and screw-coupled to the moving block.

When the leveling shaft is rotated in one direction, the moving block may be supported on the lower part of the side body, and when the leveling shaft is rotated in the other direction opposite to the one direction, the moving block may be supported on the upper part of the side body.

The side body may include: a leveling hole penetrating the lower part in the longitudinal direction of the leveling shaft; and a rim groove formed in the leveling hole and recessed into the inner side of the lower part, and the leveling shaft may include: a shaft penetrating the leveling hole and inserted into the moving block; a rim having an outer diameter greater than the outer diameter of the shaft, protruding from the shaft, and inserted into the rim groove; and a head located outside the lower part and connected to the end of the shaft.

The display device may further include: a gearbox connected to the shaft of the driving pulley and facing the light-shielding film with respect to the driving pulley; and a motor which provides rotational force to the gearbox and faces the light-shielding film.

The display device may further include a housing frame that faces the display panel with respect to the light-shielding film and is coupled to the side frame, and the driving pulley may be rotatably coupled to the housing frame.

The display device may further include a pulley mount coupled to the housing frame and accommodating the driving pulley, wherein the pulley mount may include: a flange portion fixed to the housing frame; a pulley housing connected to the flange portion to accommodate the driving pulley and in which the driving pulley rotates; a bearing mount connected to the pulley housing and covering the driving pulley; and a shaft mount through which the shaft of the driving pulley passes.

The display device may further include a bearing fixed to the bearing mount and coupled to the driving pulley to rotate together with the driving pulley.

The driving pulley may maintain a constant distance from the light-shielding film.

The display device may further include: a housing frame facing the display panel with respect to the light-shielding film and coupled to the side frame; a gearbox fixed to the housing frame, connected to the shaft of the driving pulley, and facing the light-shielding film with respect to the driving pulley; and a motor fixed to the housing frame, providing rotational force to the gearbox, and facing the light-shielding film with respect to the housing frame.

The display device may further include: a joint connecting the shaft of the driving pulley and the gearbox; and a rotary counter fixed to the shaft of the motor and rotating together with the shaft of the motor.

The embodiments of the present disclosure described above are not mutually exclusive or distinct. The respective configurations or functions of the embodiments of the present disclosure described above may be used in combination or combined.

For example, this means that configuration A described in a specific embodiment and/or drawings may be combined with configuration B described in another embodiment and/or drawings. That is, even if a combination of configurations is not directly described, it means that combination is possible except where it is described as impossible.

The above detailed description should not be interpreted restrictively in all respects and should be considered exemplary. The scope of the present disclosure should be determined by a reasonable interpretation of the appended claims, and all modifications within the equivalent scope of the present disclosure are included within the scope of the present disclosure.

## Claims

1. A display device comprising:
a display panel which displays an image and is transparent;
a transparent panel facing the display panel;
a side frame extending along a side edge of the display panel and coupled to the transparent panel;
a belt provided in the side frame and moving in a longitudinal direction of the side frame;
a bar extending in a direction intersecting the side frame and having one end fixed to the belt;
a rotatable roller adjacent to a lower edge connected to the side edge of the display panel and extending along the lower edge of the display panel;
a light-shielding film having one end fixed to the bar and the other end coupled to the roller, and wound around or unwound from the roller when the bar moves;
an upper pulley located above the side frame, the belt being wound around the upper pulley; and
a driving pulley adjacent to the lower side of the side frame, facing the light-shielding film, and rotating about a thickness direction of the light-shielding film as an axis, the belt being wound around the driving pulley,
wherein the bar comprises:
a piece body on which the light-fielding film is wound; and
a moving block moving relative to the piece body in the longitudinal direction of the side frame and coupled to the piece body, the belt is being fixed to the moving body.

2. The display device of claim 1, wherein the piece body comprises:
a main body extending in a longitudinal direction of the bar; and
a side body formed at an end of the main body and having an upper part and a lower part formed by removing the center of the side body in a longitudinal direction of the main body from the belt toward the main body,
wherein the moving block is inserted between the upper part and the lower part of the side body and moves between the upper part and the lower part.

3. The display device of claim 2, wherein the side body comprises a block guide shaft parallel to the side frame, connecting the upper part and the lower part, and inserted into the moving block, and the moving block is spaced apart from the upper part when supported on or in contact with the lower part and spaced apart from the lower part when supported on or in contact with the upper part.

4. The display device of claim 3, further comprising a belt fixer for securing the belt to the moving block.

5. The display device of claim 3, wherein the bar further comprises a leveling shaft rotatably coupled to the lower part of the side body and screw-coupled to the moving block.

6. The display device of claim 5, wherein the moving block is supported on the lower part of the side body when the leveling shaft is rotated in one direction, and the moving block is supported on the upper part of the side body when the leveling shaft is rotated in a direction opposite to the one direction.

7. The display device of claim 5, wherein the side body comprises:
a leveling hole penetrating the lower part in a longitudinal direction of the leveling shaft; and
a rim groove formed in the leveling hole and recessed into the inner side of the lower part, and
the leveling shaft comprises:
a shaft penetrating the leveling hole and inserted into the moving block;
a rim having an outer diameter greater than an outer diameter of the shaft, protruding from the shaft, and inserted into the rim groove; and
a head located outside the lower part and connected to an end of the shaft.

8. The display device of claim 1, further comprising:
a gearbox connected to the shaft of the driving pulley and facing the light-shielding film with respect to the driving pulley; and
a motor providing rotational force to the gearbox and facing the light-shielding film.

9. The display device of claim 1, further comprising a housing frame facing the display panel with respect to the light-shielding film and coupled to the side frame,
wherein the driving pulley is rotatably coupled to the housing frame.

10. The display device of claim 9, further comprising a pulley mount coupled to the housing frame and accommodating the driving pulley,
wherein the pulley mount comprises:
a flange portion fixed to the housing frame;
a pulley housing connected to the flange portion to accommodate the driving pulley, in which the driving pulley rotates;
a bearing mount connected to the pulley housing and covering the driving pulley; and
a shaft mount through which the shaft of the driving pulley passes.

11. The display device of claim 10, further comprising a bearing fixed to the bearing mount and coupled to the driving pulley to rotate together with the driving pulley.

12. The display device of claim 9, wherein the driving pulley maintains a constant distance from the light-shielding film.

13. The display device of claim 1, further comprising:
a housing frame facing the display panel with respect to the light-shielding film and coupled to the side frame;
a gearbox fixed to the housing frame, connected to the shaft of the driving pulley, and facing the light-shielding film with respect to the driving pulley; and
a motor fixed to the housing frame, providing rotational force to the gearbox, and facing the light-shielding film with respect to the housing frame.

14. The display device of claim 13, further comprising:
a joint connecting the shaft of the driving pulley and the gearbox; and
a rotary counter fixed to the shaft of the motor and rotating together with the shaft of the motor.
